# EUROPÄISCHE PATENTANMELDUNG

(11) **EP 3 693 228 A1**
(43) Veröffentlichungstag der Anmeldung: **12.08.2020**
(21) Anmeldenummer: 19156542.3
(22) Anmeldetag: 11.02.2019
(51) Int. Cl.: B60R 16/023, H05K 5/00

(54) **GEHÄUSE, INSBESONDERE FÜR HOCHVOLT-KOMPONENTEN**

(71) Anmelder: voestalpine Automotive Components Dettingen GmbH & Co. KG, 72581 Dettingen an der Erms (DE)
(72) Erfinder: Lanksweirt, Jochen, 89522 Heidenheim (DE); Joost, Tony, 08066 Zwickau (DE)
(74) Vertreter: Jell, Friedrich

(57) **Zusammenfassung**

Es werden ein Gehäuse (100), insbesondere für Hochvolt-Komponenten, ein Hochvoltverteiler und ein Fahrzeug mit diesem Gehäuse - mit einer länglichen, metallischen Gehäusebasis (1) und mit zwei Stirnwänden (3, 4). Um diese Gehäuse besonders standfest zu gestalten, wird vorgeschlagen, dass die Gehäusebasis (1) ein geschlossenes Hohlprofil (6, 60) mit vier Profilseitenwänden (6.1, 6.2, 6.3, 6.4) und mit zwei offenen Profilstirnseiten (6.5, 6.6) aufweist, und dass die aus einem Metallblech hergestellten Stirnwände (3, 4) die offenen Profilstirnseiten (6.5, 6.6) des Hohlprofils (6, 60) verschließen und mit dem Hohlprofil (6, 60) fest verbunden sind, wofür die Stirnwände (3, 4) je einen wannenförmigen Abschnitt (3.1, 4.1) und einen Endabschnitt (3.2, 4.2) aufweisen, welcher Endabschnitt (3.2, 4.2) gemeinsam mit der Wannenseitenwand (3.4, 4.4) des wannenförmigen Abschnitts (3.1, 4.1) eine außen umlaufendende und insbesondere u-förmige Aufnahme (7.1, 7.2) ausbildet, in die das Hohlprofil (6, 60) unter Anliegen an der jeweiligen Stirnwand (3, 4), insbesondere an der Wannenseitenwand (3.4, 4.4), einragt.

## Beschreibung

Die Erfindung betrifft ein Gehäuse, insbesondere für Hochvolt-Komponenten, mit einer länglichen, metallischen Gehäusebasis und mit zwei Stirnwänden.

Elektrische Verteilergehäuse mit Hochvolt-Komponenten eines Fahrzeugs bedürfen nicht nur einer robusten Konstruktion, einer Hochvoltsicherheit sowie einer Dichtheit gegenüber Umwelteinflüssen, sie müssen auch eine elektromagnetische Verträglichkeit (EMV) aufweisen, um andere elektrische/elektronische Komponenten des Fahrzeugs nicht zu stören. Ein aus der DE202015104681U1 bekanntes metallisches Hochvoltverteilergehäuse weist hierfür eine druckgegossene, längliche Gehäusebasis aus Gehäuseboden und zwei Seitenwänden und zwei Stirnseiten auf, welche Wände eine von einem Gehäusedeckel verschlossene Zugangsöffnung begrenzen. Die elektromagnetische Verträglichkeit des Verteilergehäuses wird durch eine zwischen Gehäuseunterteil und Gehäusedeckel vorgesehene, elektrisch leitfähige Dichtung hergestellt. Die Abmessungen der Gehäusebasis bestimmen die Möglichkeit, elektrische Komponenten etc. aufzunehmen bzw. beschränkt die Variabilität der Verwendung des Verteilergehäuses - womit ein universelles Einsatzgebiet vergleichswese eingeschränkt ist.

Die Erfindung hat sich daher ausgehend vom eingangs geschilderten Stand der Technik die Aufgabe gestellt, die Konstruktion des Gehäuses derart zu verändern, dass bei hoher Hochvoltsicherheit, elektromagnetischer Verträglichkeit sowie Dichtheit gegenüber Umwelteinflüssen eine variable Anpassung der Abmessungen des Verteilgehäuses möglich wird.

Die Erfindung löst die gestellte Aufgabe durch die Merkmale des Anspruchs 1.

Weist die Gehäusebasis ein geschlossenes Hohlprofil mit vier Profilseitenwänden und mit zwei offenen Profilstirnseiten auf, kann zunächst ein in den Längsabmessungen variabel auszubildendes Gehäuse zur Verfügung gestellt werden - und zwar beispielsweise durch einfache Änderungen im Zuschnitt. Im Allgemeinen wird erwähnt, dass das geschlossene Hohlprofil ein Strangpressprofil, Blechprofil etc. sein.

Die genannten Vorteile sind besonders dadurch erreichbar, dass die aus einem Metallblech hergestellten Stirnwände die offenen Profilstirnseiten des Hohlprofils verschießen und mit dem Hohlprofil fest verbunden sind, wofür die Stirnwände je einen wannenförmigen Abschnitt und einen Endabschnitt aufweisen, welcher Endabschnitt gemeinsam mit der Wannenseitenwand des wannenförmigen Abschnitts eine außen umlaufendende und insbesondere u-förmige Aufnahme ausbildet, in die das Hohlprofil unter Anliegen an der jeweiligen Stirnwand einragt. Unter anderem besonders einfach kann das Anliegen des Holprofils an der an der jeweiligen Stirnwand als Anliegen an der Wannenseitenwand erfolgen.

Auf diese Weise - nämlich durch den anliegenden Eingriff des Hohlprofils in die Aufnahme der jeweiligen Stirnwand - ist auf einfache und sichere Weise an der jeweiligen offenen Profilstirnseiten eine elektromagnetische Abschirmung zu schaffen. Beispielsweise können damit nicht nur die elektrischen/elektronischen Baugruppen im Gehäuse vor Funktionsstörungen geschützt werden, sondern auch jene außerhalb des Gehäuses. Des Weiteren bietet eine u-förmige Aufnahme auch einen Schutz vor mechanischen Belastungen, etwa auch für eine Dichtungsmasse bzw. für eine Dichtung in der Aufnahme.

Das erfindungsgemäße Gehäuse kann sich daher durch hohe Hochvoltsicherheit, Dichtheit sowie elektromagnetische Verträglichkeit auszeichnen - und bietet vielseitige Anwendungsmöglichkeiten aufgrund der einfach und kostengünstig gewährleisteten Variabilität in seinen Abmessungen.

Die elektromagnetische Verträglichkeit des Gehäuses ist weiter verbesserbar, wenn Hohlprofil und Stirnwände über Stauch-Press-Verbindungen, insbesondere über Clinch-Verbindungen, fest miteinander verbunden sind. Insbesondere können sich hier formschlüssige Clinch-Verbindungen (hergestellt durch ein Durchsetzfügen) eignen, um den elektrischen Übergangswiderstand gering zu halten und eine elektromagnetische Dichtigkeit des Gehäuses zu garantieren. Derartige Verbindungen verbessern aber auch die Formstabilität des Gehäuses.

Die Widerstandfähigkeit des Gehäuses gegenüber Umwelteinflüssen kann erhöht werden, wenn in der Aufnahme eine, insbesondere umlaufende, Dichtungsmasse vorgesehen ist. Solch eine Dichtungsmasse kann ein dichtender Klebstoff, eine Dichtung, etc. sein.

Thermische oder mechanische Belastungen des Gehäuses können von der Dichtungsmasse verbessert aufgenommen werden, wenn die Dichtungsmasse zwischen Aufnahme und Stirnfläche des Hohlprofils gequetscht vorgesehen ist.

Die Konstruktion ist weiter vereinfachbar, wenn eine O-Ringdichtung die Dichtungsmasse ausbildet.

Die Handhabung des Gehäuses kann sich erleichtern, wenn mindestens eine Stirnwand an ihrem Wannenboden eine zweite Zugangsöffnung und einen diese zweite Zugangsöffnung verschließenden Deckel aufweist, der von der Stirnwand abnehmbar ist. Über diese stirnseitige Zugangsöffnung besteht nämlich auch bei geschlossenem Gehäusedeckel eine Zugangsmöglichkeit zum Gehäuseinneren, was Maßnahmen zur Wartung und Inspektion der vom Gehäuse aufgenommen elektrischen/elektronischen Mittel erleichtern kann.

Vorzugsweise weist das Gehäuse einen, insbesondere flachen, metallischen Gehäusedeckel auf. Zudem ist in der vierten Profilseitenwand eine erste Zugangsöffnung eingebracht, die den, von der Gehäusebasis lösbaren Gehäusedeckel verschließt, wodurch das Gehäuse handhabungsfreundlich bestückt werden kann, beispielsweise mit elektronischen/elektrischen Mitteln. Zudem kann das geschlossene Hohlprofil die erste Zugangsöffnung dadurch besonders formgenau ausbilden. Dieses Einbringen ist etwa durch Trennen möglich - was demnach ebenfalls auf einfache Weise an die jeweils vorliegenden Erfordernisse abzustimmen ist. Zugangsöffnung und Gehäusedeckel können sich so durch hohe Passgenauigkeit auszeichnen, was nicht nur Hochvoltsicherheit und Dichtheit, sondern auch elektromagnetische Verträglichkeit sicherstellen kann.

Ist in der vierten Profilseitenwand die erste Zugangsöffnung mittig eingebracht, ist die Handhabung des Gehäuses bei ihrer Bestückung mit elektrischen/elektronischen Bauteilen/Bauelementen/Schaltungen etc. zu erleichtern.

Ist die Zugangsöffnung in einer Vertiefung, insbesondere 45 Grad Durchstellung, in die vierte Profilseitenwand eingebracht, kann dies die nicht nur zur Versteifung des Öffnungsrands der Zugangsöffnung beitragen, sondern auch die EMV-Dichtheit des Gehäuses weiter verbessern.

Vorzugsweise weist das Gehäuse einen innenliegenden Träger auf, der über Stauch-Press-Verbindungen, insbesondere über Clinch-Verbindungen, mit der ersten Profilseitenwand fest verbunden ist. Damit kann eine einfach handhabbare Möglichkeit geschaffen werden, elektronische und/oder elektrische Mittel und/oder elektrische Anschlüsse - vorzugsweise auf Hochvolt-Komponenten - im Gehäuse zu befestigen.

Weist das aus einem Metallblech hergestellte, geschlossene Hohlprofil eine Längsschweißnaht auf, kann sich die Herstellung des Gehäuses erleichtern bzw. sind damit dessen Herstellungskosten weiter reduzierbar.

Die Crashsicherheit der vom Gehäuse aufgenommenen Elemente kann erhöht werden, wenn das Hohlprofil mehrkammerig ausgebildet ist und/oder seitliche abstehende Energieabsorberelemente aufweist. Zudem kann das Gehäuse eine verbesserte Kühlung aufweisen, wenn es - vorzugsweise seitlich abstehende - Kühlrippen aufweist.

Vorzugsweise weist das Gehäuse elektronische und/oder elektrische Mittel - insbesondere eine Hochvolt-Komponente, und/oder elektrische Anschlüsse auf. Dies insbesondere auch unter dem Aspekt der besonderen EMV-Abschirmung durch das erfindungsgemäße Gehäuse.

Hohlprofil und/oder Stirnwände bestehen aus einer Aluminiumlegierung, vorzugsweise des Typs 6xxx. Dies ist nicht nur der EMV-Abschirmung dienlich, sondern kann auch ein vergleichsweise leichtes Gehäuse schaffen.

Besonders kann sich das erfindungsgemäße Gehäuse für einen Hochvoltverteiler als Hochvoltverteilergehäuse eignen.

Des Weiteren kann sich das erfindungsgemäße Gehäuse oder Hochvoltverteilergehäuse für ein Fahrzeug, insbesondere Kraftfahrzeug, besonders eignen.

In den Figuren ist beispielsweise der Erfindungsgegenstand anhand mehrere Ausführungsvarianten näher dargestellt. Es zeigen
Fig. 1 eine Seitenansicht auf ein Gehäuse,
Fig. 2 eine vergrößerte Detailansicht des nach Fig. 1 dargestellten Gehäuses,

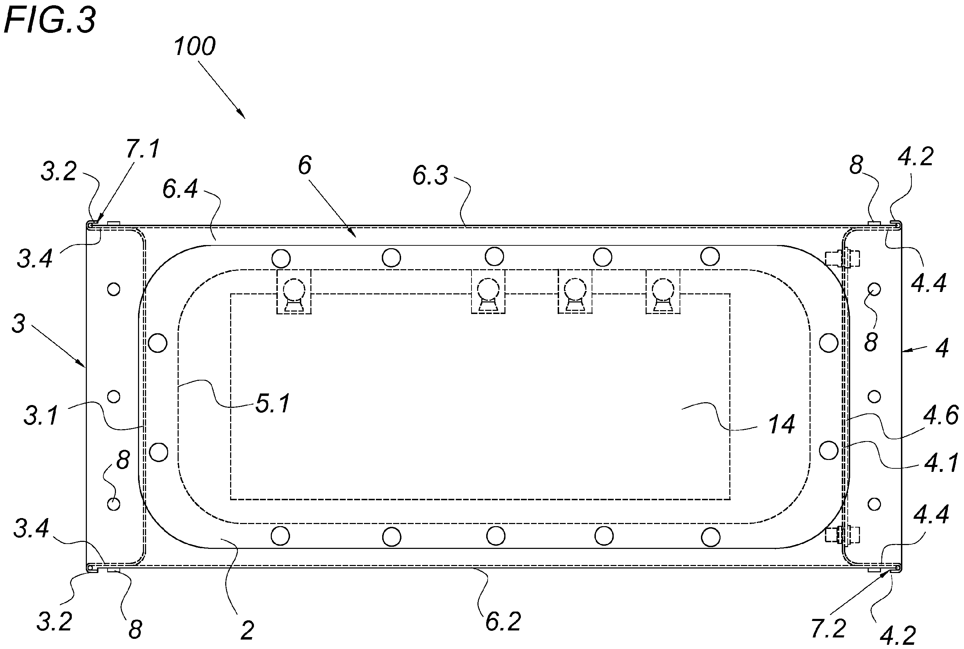

Fig. 3 eine Draufsicht auf das nach Fig. 1 dargestellte Gehäuse,
Fig. 4 eine vergrößerte Detailansicht des nach Fig. 1 dargestellten Gehäuses und

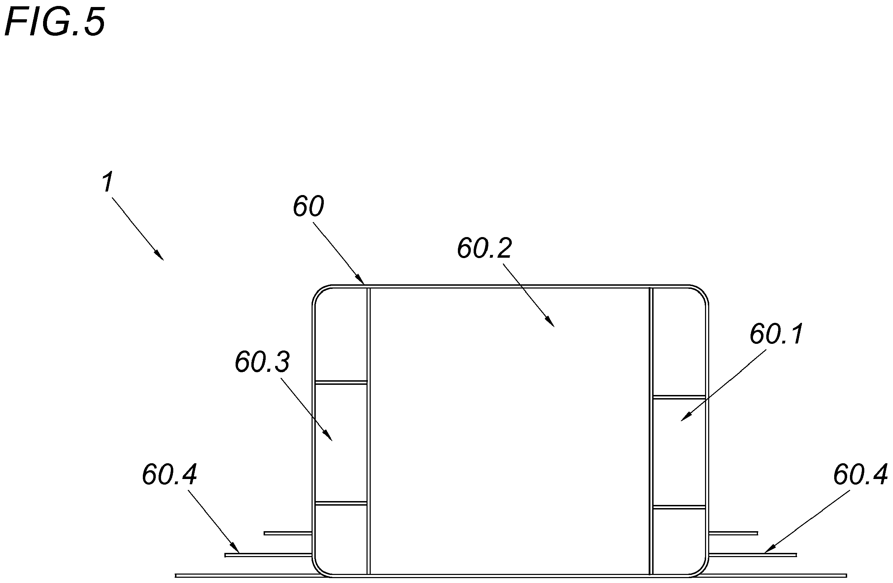

Fig. 5 eine alternative Ausführung eines Hohlprofils des Gehäuses nach Fig. 1.

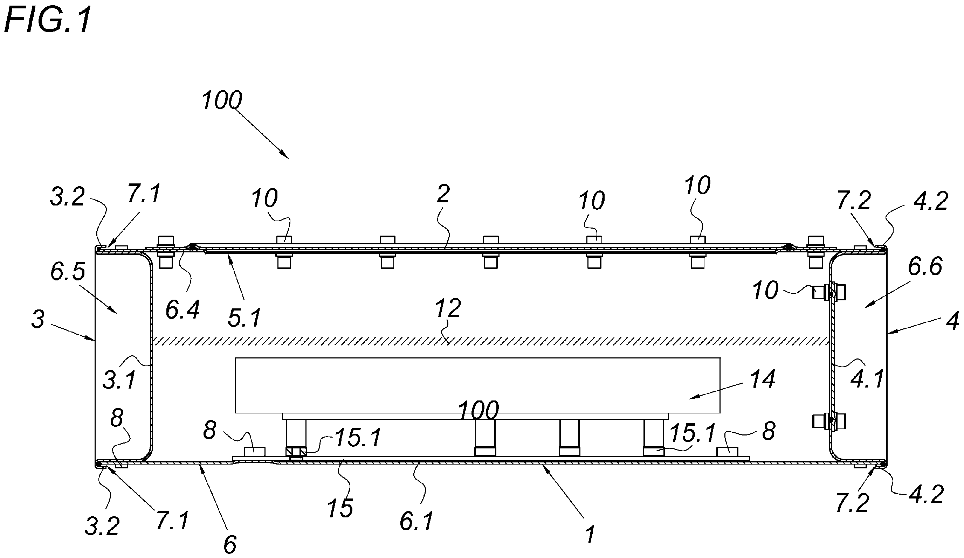

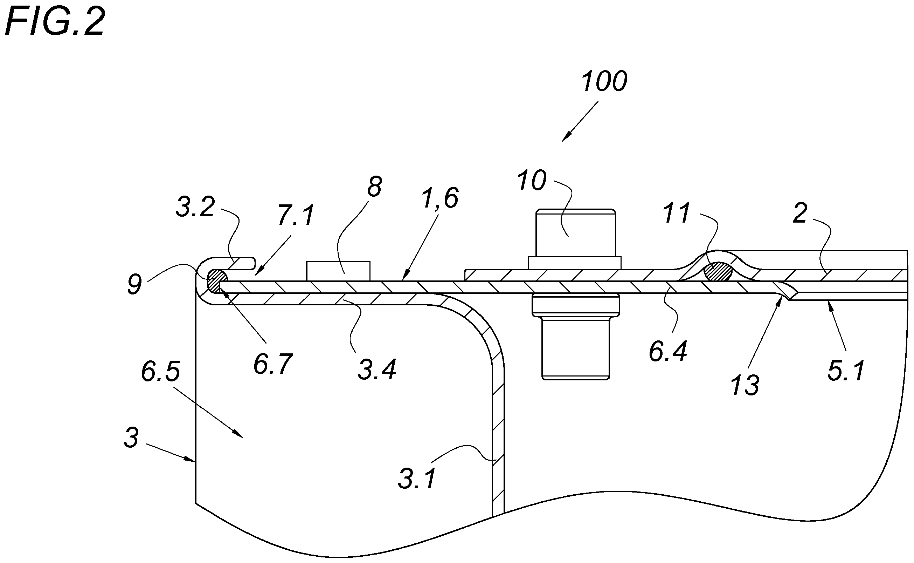

Nach den Figuren 1 und 2 wird ein metallisches Gehäuse 100, nämlich Verteilergehäuse, eines nicht dargestellten Hochvoltverteilers in einem Fahrzeug gezeigt. Dieses Gehäuse 100 weist eine längliche, metallische Gehäusebasis 1 sowie zwei Stirnwände 3, 4, einen Gehäusedeckel 2 und eine erste Zugangsöffnung 5.1 auf. Diese erste Zugangsöffnung 5.1 ist durch den, von der Gehäusebasis 1 abnehmbaren metallischen Gehäusedeckel 2 dicht, insbesondere EMV-dicht, verschlossen. Im Gehäuse 100 sind beispielsweise elektrische/elektronische Mittel 14 als eine Hochvolt-Komponente vorgehen.

Erfindungsgemäß werden die anderen Gehäuseseiten der Gehäusebasis 1 von einem geschlossenen Hohlprofil 6 nach einem ersten Ausführungsbeispiel ausgebildet. Das geschlossene Hohlprofil 6 wird aus einem Metallblech hergestellt, beispielsweise mit Hilfe eines Blechumformverfahrens, wie Rollprofilieren. Nach dem Umformen wird das Metallblech längsverschweißt, wobei die Längsschweißnaht 12 am Hohlprofil 6 in Fig. 1 angedeutet dargestellt ist.

Durch diesen als Hohlprofil 6 ausgebildeten Teil der Gehäusebasis 1 eröffnet sich die Möglichkeit, das Verteilgehäuse 1 an gewünschte Außenabmessungen einfach und kostengünstig anzupassen. Dieses Anpassen kann beispielsweise durch Ablängen des Hohlprofils 6 erfolgen.

Demnach bildet das Hohlprofil 6 die Seiten der Gehäuse 100 aus, nämlich mit seinen vier Profilseitenwänden 6.1, 6.2, 6.3, 6.4 den Gehäuseboden als erste Profilseitenwand 6.1, zwei Gehäuselängsseiten als zweite und dritte Profilseitenwand 6.2, 6.3 und eine Gehäusedeckelwand als vierte Profilseitenwand 6.4.

In der Gehäusedeckelwand als vierte Profilseitenwand 6.4 ist die erste Zugangsöffnung 5.1, vorzugsweise mittig, eingebracht - beispielsweise durch ein Stanzverfahren. Dies stellt eine formgenaue Ausbildung der ersten Zugangsöffnung 5.1 sicher - und sorgt zuverlässig für einen gegenüber Umwelteinflüssen dichten Abschluss des Gehäuses 100. Die Zugangsöffnung 5.1 ist zudem in einer Vertiefung 13, nämlich in einer 45 Grad Durchstellung, in der vierten Profilseitenwand 6.4 eingebracht, was bei aufgesetztem metallischen Gehäusedeckel 2 die EMV-Abschirmung des Gehäuses 100 sicherstellt.

Das Hohlprofil 6 ist an seinen beiden offenen Profilstirnseiten 6.5, 6.6 mit Stirnwänden 3, 4 verschlossen und mit diesen Stirnwänden 3, 4 fest verbunden.

Zum standfesten Anbinden und Verschließen des Hohlprofils 6 weisen die Stirnwände 3, 4 je einen wannenförmigen Abschnitt 3.1, 4.1 und einen Endabschnitt 3.2, 4.2 auf. Der Endabschnitt 3.2, 4.2 bilden gemeinsam mit dem wannenförmigen Abschnitt 3.1, 4.1 eine außen umlaufendende und u-förmige Aufnahme 7.1, 7.2 aus. Diese Stirnwände 3, 4 sind ebenfalls jeweils aus einem Metallblech hergestellt - im Ausführungsbeispiel unter Nutzung eines Blechumformverfahrens, etwa eines Tiefziehens.

In diese Aufnahme 7.1, 7.2 ragt das Hohlprofil 6 ein und liegt dort an die jeweilige Stirnwand 3, 4 - im Ausführungsbeispiel an die Wannenseitenwand 3.4, 4.4 an. Auf diese Weise wird ein elektrischer Kontakt zwischen dem metallischen Hohlprofil 6 und den metallischen Stirnwänden 3, 4 sichergestellt. Dies behindert die Abstrahlung bzw. den Empfang von elektromagnetischer Strahlung durch das Verteilgehäuse 100 bzw. sorgt für eine standfeste Gehäuseabschirmung gegenüber elektromagnetischen Störungen.

Hohlprofil 6 und Stirnwände 3, 4 sind über Stauch-Press-Verbindungen 8, insbesondere über Clinch-Verbindungen, fest miteinander verbunden - was auch bei mechanischen Belastungen auf das Gehäuse 100 stets einen elektrischen Kontakt zwischen diesen sicherstellt. Das Gehäuse 100 ist daher gegenüber elektromagnetischen Störungen besonders dicht.

In der Aufnahme 7.1, 7.2 ist zudem je eine umlaufende Dichtungsmasse 9 vorgesehen, die als O-Ringdichtung ausgeführt ist. Diese Dichtungsmasse 9 ist zwischen Aufnahme 7.1 bzw. 7.2 und Stirnfläche 6.7 des Hohlprofils 6 gequetscht vorgesehen, was die Dichtheit des Gehäuses 100 weiter erhöht.

Zudem werden durch diese Vorspannung mechanische Formänderungen am Gehäuse 100 - ohne Verlust des dichten Abschlusses - aufgenommen, womit eine besonders hohe Standfestigkeit des Gehäuse 100 sicherzustellen ist.

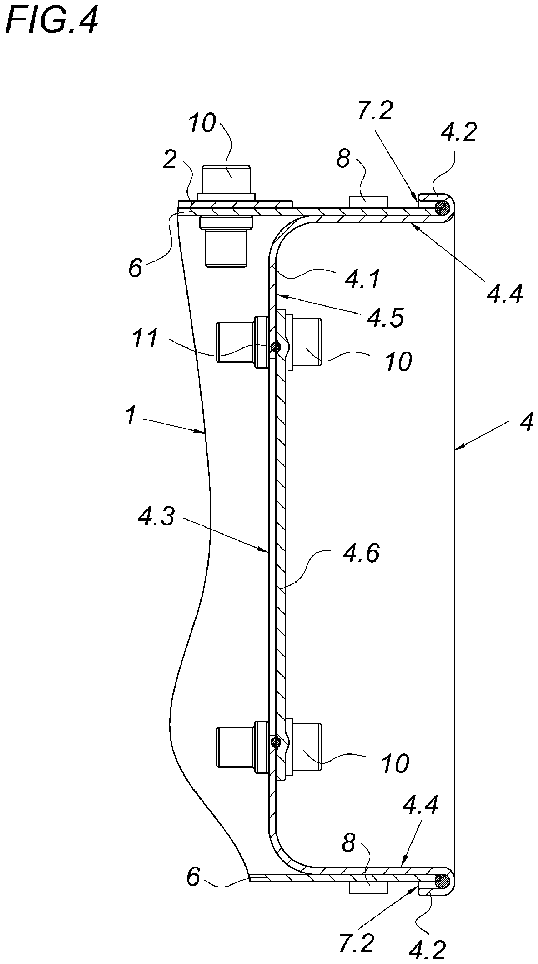

Wie nach Fig. 4 zu erkennen, ist an der zweiten Seitenwand 4 eine zweite Zugangsöffnung 4.3 vorgesehen. Diese zweite Zugangsöffnung 4.3 befindet sich im Wannenboden 4.5 des wannenförmigen Abschnitts 4.1 der zweiten Stirnwand 4 und wird vom Deckel 4.6 verschlossen. Dieser aus einem Metallblech gefertigte Deckel 4.6 ist gleich wie der Gehäusedeckel 2 über lösbare Schraubverbindungen 10, beispielsweise aus Schrauben und Stanznieten mit Gegengewinde für diese Schrauben, von der jeweiligen Zugangsöffnung 4.3 bzw. 5.1 abnehmbar. Über diese stirnseitliche Zugangsmöglichkeit ist das Gehäuse 100 besonders einfach zu warten, was dessen Handhabbarkeit verbessert. Auch ist zwischen dem Wannenboden 4.5 und dem Deckel 4.6 ein zweites umlaufendes Dichtelement 11 vorgesehen - um wiederum auch um EMV-Dichtheit zu gewährleisten.

Das Gehäuse 100 weist zudem einen innenliegenden Träger 15 auf, der über Stauch-Press-Verbindungen 8, nämlich über Clinch-Verbindungen, mit der ersten Profilseitenwand 6.1 fest verbunden ist. Der Träger weist Befestigungselemente 15.1, nämlich Einpressmuttern auf, an denen die elektronischen/elektrischen Mittel 14, insbesondere Hochvolt-Komponenten befestigt werden können.

Die Crashsicherheit der vom Gehäuse 100 aufgenommenen elektronischen/elektrischen Mittel 14 wird durch ein mehrkammeriges Hohlprofil 60 nach einem zweiten Ausführungsbeispiel erhöht. Dieses vorzugsweise stranggepresste Hohlprofil 60, insbesondere aus einer Aluminiumlegierung, weist vorzugsweise mehrere Kammern 60.1, 60.2 und 60.3 auf. In der mittleren Kammer 60.2 werden die elektronischen/elektrischen Mittel 14 ausreichend geschützt aufgenommen. Seitlich an den Längsseiten stehen Energieabsorberelemente 60.4 ab, die im Falle eines Crashs Crashenergie durch Verformung absorbieren.

Besonders kann das Gehäuse 100 im Hochvoltbereich Verwendung finden, beispielsweise als High-Voltage-Distribution-Box bzw. Leistungsverteiler, Batteriemanagementsystem, Ladeelektronik für eine Batterie oder Leistungselektronik für einen Motor etc.

Insbesondere, ist das Gehäuse 100 dazu geeignet, eine Hochvolt-Komponente EMV geschützt aufzunehmen - Beispiele einer Hochvolt-Komponente sind etwa: elektrischer Energiespeicher, Inverter, elektrische Verbindungen einer Hochvolt-Leitung etc.

## Patentansprüche

1. Gehäuse, insbesondere für Hochvolt-Komponenten, mit einer länglichen, metallischen Gehäusebasis (1) und mit zwei Stirnwänden (3, 4), **dadurch gekennzeichnet, dass** die Gehäusebasis (1) ein geschlossenes Hohlprofil (6, 60) mit vier Profilseitenwänden (6.1, 6.2, 6.3, 6.4) und mit zwei offenen Profilstirnseiten (6.5, 6.6)aufweist, und dass die aus einem Metallblech hergestellten Stirnwände (3, 4) die offenen Profilstirnseiten (6.5, 6.6) des Hohlprofils (6, 60) verschließen und mit dem Hohlprofil (6, 60) fest verbunden sind, wofür die Stirnwände (3, 4) je einen wannenförmigen Abschnitt (3.1, 4.1) und einen Endabschnitt (3.2, 4.2) aufweisen, welcher Endabschnitt (3.2, 4.2) gemeinsam mit der Wannenseitenwand (3.4, 4.4) des wannenförmigen Abschnitts (3.1, 4.1) eine außen umlaufendende und insbesondere u-förmige Aufnahme (7.1, 7.2) ausbildet, in die das Hohlprofil (6, 60) unter Anliegen an der jeweiligen Stirnwand (3, 4), insbesondere an der Wannenseitenwand (3.4, 4.4), einragt.

2. Gehäuse nach Anspruch 1, **dadurch gekennzeichnet, dass** Hohlprofil (6, 60) und Stirnwände (3, 4) über Stauch-Press-Verbindungen (8), insbesondere über Clinch-Verbindungen, fest miteinander verbunden sind.

3. Gehäuse nach Anspruch 1 oder 2, **dadurch gekennzeichnet, dass** in der Aufnahme (7.1, 7.2) eine, insbesondere umlaufende, Dichtungsmasse (9) vorgesehen ist.

4. Gehäuse nach Anspruch 3, **dadurch gekennzeichnet, dass** die Dichtungsmasse (9) zwischen Aufnahme (7.1, 7.2) und Stirnfläche (6.7) des Hohlprofils (6, 60) gequetscht vorgesehen ist.

5. Gehäuse nach Anspruch 3 oder 4, **dadurch gekennzeichnet, dass** eine O-Ringdichtung die Dichtungsmasse (9) ausbildet.

6. Gehäuse nach einem der Ansprüche 1 bis 5, **dadurch gekennzeichnet, dass** mindestens eine Stirnwand (4) an ihrem Wannenboden (4.5) eine zweite Zugangsöffnung (4.3) und einen diese zweite Zugangsöffnung (4.3) verschließenden Deckel (4.6) aufweist, der von der Stirnwand (4) abnehmbar ist.

7. Gehäuse nach einem der Ansprüche 1 bis 6, **dadurch gekennzeichnet, dass** das Gehäuse (100) einen, insbesondere flachen, metallischen Gehäusedeckel (2) aufweist, und dass, insbesondere mittig, in der vierten Profilseitenwand (6.4) eine erste Zugangsöffnung (5.1) eingebracht ist, die den, von der Gehäusebasis (1) lösbaren Gehäusedeckel (2) verschließt.

8. Gehäuse nach Anspruch 7, **dadurch gekennzeichnet, dass** die Zugangsöffnung (5.1) in einer Vertiefung (13), insbesondere 45 Grad-Durchstellung, in die vierte Profilseitenwand (6.4) eingebracht ist.

9. Gehäuse nach einem der Ansprüche 1 bis 8, **dadurch gekennzeichnet, dass** das Gehäuse (100) einen innenliegenden Träger (15) aufweist, der über Stauch-Press-Verbindungen (8), insbesondere über Clinch-Verbindungen, mit der ersten Profilseitenwand (6.1) fest verbunden ist.

10. Gehäuse nach einem der Ansprüche 1 bis 9, **dadurch gekennzeichnet, dass** das aus einem Metallblech hergestellte, geschlossene Hohlprofil (6, 60) eine Längsschweißnaht (12) aufweist.

11. Gehäuse nach einem der Ansprüche 1 bis 10, **dadurch gekennzeichnet, dass** das Hohlprofil mehrkammerig ausgebildet ist und/oder seitlich abstehende Energieabsorberelemente (60.4) oder Kühlrippen aufweist.

12. Gehäuse nach einem der Ansprüche 1 bis 11, **dadurch gekennzeichnet, dass** das Gehäuse (100) elektronische und/oder elektrische Mittel (14), insbesondere eine Hochvolt-Komponente, und/oder elektrische Anschlüsse aufweist.

13. Gehäuse nach einem der Ansprüche 1 bis 12, **dadurch gekennzeichnet, dass** das Hohlprofil (1) und/oder die Stirnwände (3, 4) aus einer Aluminiumlegierung bestehen.

14. Hochvoltverteiler mit einem Gehäuse (100) nach einem der Ansprüche 1 bis 13.

15. Fahrzeug, insbesondere Kraftfahrzeug, mit einem Gehäuse (100) nach einem der Ansprüche 1 bis 13 oder mit einem Hochvoltverteiler nach Anspruch 14.
